# EUROPEAN PATENT APPLICATION

(11) **EP 0 574 207 A2**
(43) Date of publication of application: **15.12.1993**
(21) Application number: 93304382.0
(22) Date of filing: 04.06.1993
(51) Int. Cl.: H05K 3/46, H05K 1/14

(54) **Multilayer printed circuit board and method for manufacturing the same**

(30) Priority: 08.06.1992 JP 173798/92
(71) Applicant: Nippon CMK Corp., Iruma-Gun Saitama (JP)
(72) Inventor: Matsumoto, Masuo, Iruma-gun, Saitama (JP); Birukawa, Fusao, Iruma-gun, Saitama (JP); Takahashi, Takazo, Iruma-gun, Saitama (JP); Shirai, Junzaburo, Iruma-gun, Saitama (JP); Kojima, Mikiya, Iruma-gun, Saitama (JP)
(74) Representative: Boydell, John Christopher

(57) **Abstract**

[Object] To provide a structure in which the volume of mounted electronic components is increased over the prior art.

[Constitution] Hybrid modules 14, 15 are die-bonded to bonding lands 13 of an inner substrate 1. Outer substrates 2, 3 are laminated to the inner substrate 1 so that the hybrid modules are sandwiched between the inner substrate 1 and the outer substrates 2, 3. Connection holes 2, 3 are formed in the outer substrates 2, 3, and plating treatment is performed so that the hybrid modules 14, 15 are electrically connected to the outer substrates 2, 3. The hybrid modules 14, 15 each have an electronic component, such as a resistor, a capacitor or a semiconductor chip, disposed therein. Accordingly, the resultant multilayer printed circuit board assumes a structure such that electronic components are buried in the substrate laminate. Due to this burying in the substrate laminate in addition to the mounting of electronic components on the outer surfaces of the substrate laminate, the multilayer printed circuit board of the present invention can have an increased volume of electronic components disposed therein.

## Description

The present invention relates to a multilayer printed circuit board and a method for manufacturing the same. More particularly, the present invention is concerned with a multilayer printed circuit board having a structure such that electronic components are buried in the board so that the board can have an increased volume of electronic components disposed therein, and a method for manufacturing such a multilayer printed circuit board.

### Discussion of Related Art

In the art, a multilayer printed circuit board comprising a plurality of printed circuit substrates is used in various apparatus, such as data processing machines, electronic business machines and home appliances, in which a high integration of circuits is required. In the multilayer printed circuit board, the high integration of circuits is ensured by the use of connection holes, such as blind via-holes and interstitial via-holes, which mutually electrically connect the circuits included in the board. In the industry of electronic components as well, development efforts are being made for smaller chips, for higher integration as seen in a chip network resistor, and for an LSI having a small lead pitch, such as phai chip QFF. Developed precision electronic components are mounted on a printed circuit substrate by a newly developed soldering technique. As a result of the above-mentioned realization of a high integration of circuits in a multilayer printed circuit board and the above-mentioned development of precision electronic components, the multilayer printed circuit board can have a large volume of electronic component mounted thereon. However, in the art, there is still a strong demand for a further increase in the volume of electronic components mounted on the multilayer printed circuit board.

### Summary of The Invention

With a view toward meeting the demand in the art for a further increase in the volume of electronic components mounted on a multilayer printed circuit board, the present inventors have made extensive and intensive studies. As a result, they have unexpectedly found that the demand can be met by a structure such that electronic components are buried in a multilayer printed circuit board having, mounted on its surface, electronic components. Based on this novel finding, the present invention has been completed.

It is, therefore, an object of the present invention to provide a multilayer printed circuit board having an increased volume of electronic components disposed therein.

It is another object of the present invention to provide a method for effectively manufacturing such a multilayer printed circuit board having an increased volume of electronic components disposed therein.

The foregoing and other objects, features and advantages of the present invention will become apparent from the following detailed description and appended claims taken in connection with the accompanying drawings.

### Brief Description of The Drawings

In the drawings:
Fig. 1 is a block diagram illustrating the steps of a method for manufacturing a multilayer printed circuit board according to one embodiment of the present invention;
Fig. 2 is a sectional view of an inner substrate for use in the multilayer printed circuit board of the present invention;
Fig. 3 is a sectional view of an inner substrate having hybrid modules die-bonded thereto;
Fig. 4 is a sectional view of an inner substrate having hybrid modules die-bonded thereto and further having outer substrates laminated thereto to obtain a preliminary multilayer printed circuit board according to one embodiment of the present invention;
Fig. 5 is a sectional view of the preliminary multilayer printed circuit board in which connection holes have been formed;
Fig. 6 is a sectional view of the preliminary multilayer printed circuit board having connection holes which has been subjected to plating treatment;
Fig. 7 is a sectional view of a multilayer printed circuit board according to one embodiment of the present invention which has been obtained by a circuit formation on the above-mentioned plated preliminary printed circuit board; and
Fig. 8 shows a section of the resultant multilayer printed circuit board according to one embodiment of the present invention.

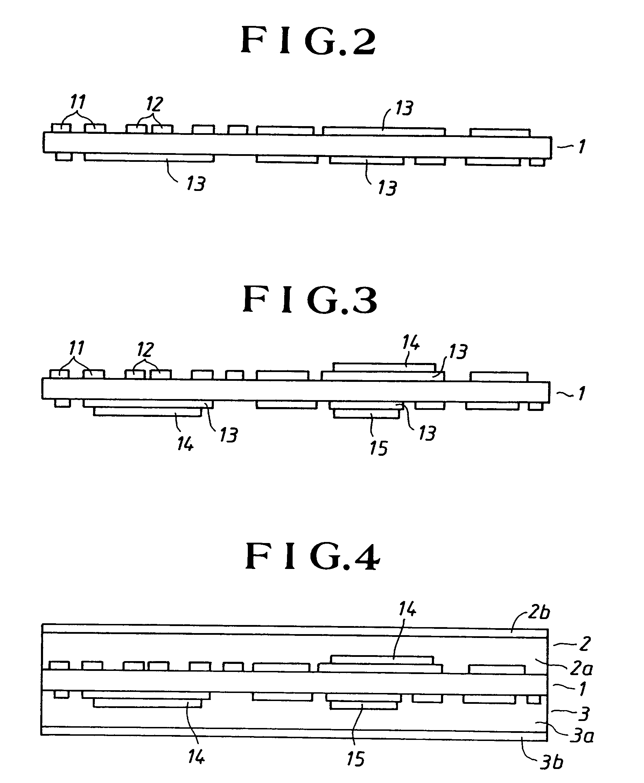

In Figs. 2 through 8, like parts or portions are designated by like numerals.

### Detailed Description of The Invention

In one aspect of the present invention to attain the above object, there is provided a multilayer printed circuit board comprising an inner printed circuit substrate having a hybrid module with electronic component functions die-bonded thereto and at least one outer printed circuit substrate laminated to said inner printed circuit substrate so that said hybrid module is sandwiched between said inner printed circuit substrate and said outer printed circuit substrate.

In another aspect of the present invention, there is provided a method for manufacturing a multilayer printed circuit board, comprising the steps of:
(1) die-bonding a hybrid module with electronic component functions to an inner substrate having a circuit formed thereon,
(2) laminating at least one outer substrate to said inner substrate so that said hybrid module is sandwiched between said outer substrate and said inner substrate,
(3) forming connection holes in said outer substrate at least at a portion corresponding to a land of said hybrid module, and
(4) electrically connecting said hybrid module with said outer substrate through said connection hole formed at the portion corresponding to the land of the hybrid module.

The thus manufactured multilayer printed circuit board assumes a structure such that a hybrid module having electronic component functions or electronic component network functions is sandwiched between printed circuit substrates, so that the condition arises that the electronic component or electronic circuit functions are buried in the layered printed circuit board. Due to this burying of the electronic component or electronic circuit functions in addition to the mounting of electronic components on the outer surfaces of the substrate laminate, the multilayer printed circuit board of the present invention can have an increased volume of electronic components disposed therein.

The multilayer printed circuit board provided with electronic component or electronic circuit functions is effectively manufactured by the method of the present invention, in which a hybrid module is die-bonded to an inner substrate, followed by lamination of at least one outer substrate, then connection holes are formed in the outer substrate, and thereafter the outer substrate is electrically connected to the hybrid module through the connection holes.

### Preferred Embodiment of The Invention

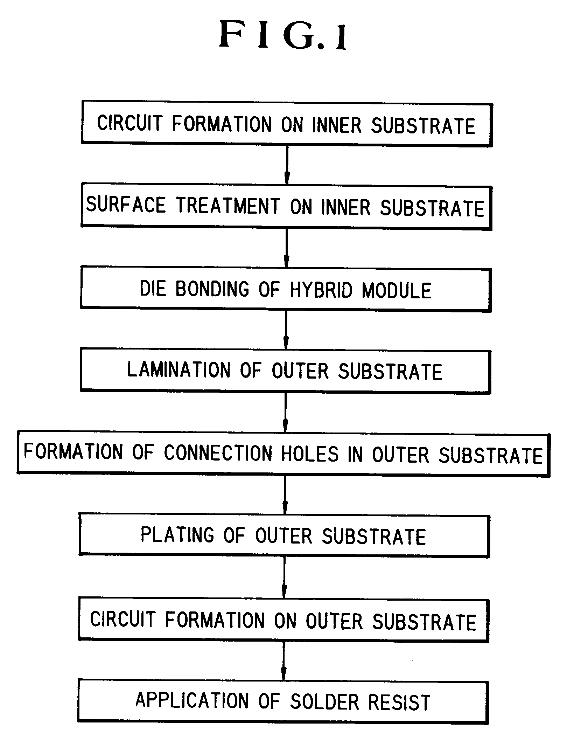

Fig. 1 shows a sequence of steps to be taken in the manufacturing method according to one embodiment of the present invention. Figs. 2 to 8 show sectional views of respective articles produced in the steps. In the following Example, a four conductor layer printed circuit board is described, comprising an inner substrate 1 and, laminated to an upper surface and a lower surface of the inner substrate 1, two outer substrates 2, 3. In the four conductor layer printed circuit board, a first circuit conductor is formed on the upper surface of the upper outer substrate 2, a second circuit conductor formed on the upper surface of the inner substrate 1, a third circuit conductor formed on the lower surface of the inner substrate land a fourth circuit conductor formed on the lower surface of the lower outer substrate 3.

A substrate having both sides thereof clad with a copper foil is provided, and the copper foils are subjected to a treatment comprising application of a photosensitive resin, light exposure and etching for forming a pattern comprising e.g., a circuit 11, a land 12 and a bonding land 13, on both of the sides of the substrate, thereby obtaining an inner substrate 1, as illustrated in Fig. 2. The inner substrate 1 is surface treated, and hybrid modules 14, 15 are die-bonded to the bonding lands 13 of the inner substrate 1, as illustrated in Fig. 3. The die-bonding of the hybrid modules 14, 15 to respective bonding lands 13 is performed through a conductive or a non-conductive adhesive.

Each of the hybrid modules has electronic component functions. For example, it is selected from a module comprising a ceramic substrate and, disposed thereon or therein, a passive component, such as a resistor and a capacitor; a module comprising a ceramic substrate and, disposed thereon or therein, an active component, such as a transistor, a diode, an IC or an LSI; and a module comprising a ceramic substrate and, disposed thereon or therein, a passive component in combination with an active component. In particular, preferably, the hybrid module comprises a ceramic substrate and, disposed thereon or therein, a circuit formed of passive and active components electrically connected in a network fashion. The hybrid module has lands (not shown) for electrically connecting these passive and active components with circuits on the inner substrate 1 and the outer substrates 2, 3. The above-mentioned lands are formed by plating of copper, its alloy or other conductive metals. As described below, a hybrid module is sandwiched between the inner substrate 1 and the outer substrate, 2, 3. It is preferred that the thickness of such a hybrid module be small. In this particular Example, the hybrid module 14 is a circuit module including a plurality of passive components, such as a resistor and a capacitor, electrically connected with each other and arranged in an array fashion, while the other hybrid module 15 is a module including a semiconductor chip.

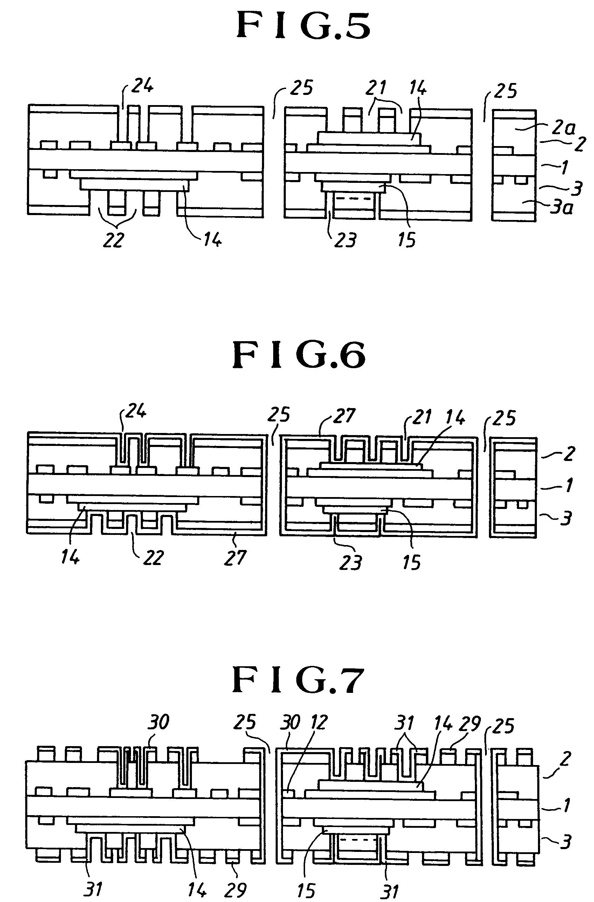

Fig. 4 illustrates a structure obtained by laminating outer substrates 2, 3 to an upper surface and a lower surface, respectively, of the inner substrate 1 after the die-bonding of the hybrid modules 14, 15 to the inner substrate 1. The lamination of the outer substrates 2, 3 is generally performed by pressing, roll lamination and/or an adhesive. The outer substrates 2, 3 respectively comprise insulating layers 2a, 3a which are, on one side thereof, clad with copper foils 2b, 3b, respectively. After the lamination of the outer substrates 2, 3, the respective copper foils 2b, 3b are subjected to a treatment comprising application of a photosensitive resin, light exposure and etching for pattern formation. Then, the insulating layers 2a, 3a are partially removed by chemical dissolution or laser irradiation at portions corresponding to portions of the copper foils 2b, 3b removed as a result of the above-mentioned treatment for pattern formation, thereby forming connection holes as shown in Fig. 5.

Fig. 5 illustrates a structure in which the connection holes have been formed in the outer substrates 2, 3. In this Example, the connection holes are at least formed at portions corresponding to lands of the hybrid modules 14, 15. A connection hole 21 corresponds to a land of the hybrid module 14 disposed on the upper side of the inner substrate 1. A connection hole 22 corresponds to a land of the hybrid module 14 disposed on the lower side of the inner substrate 1. A connection hole 23 corresponds to a land of the hybrid module 15. In Fig. 5, numeral 24 designates a connection hole formed at a portion corresponding to a land 12 of the inner substrate 1. Numeral 25 designates a connection hole formed so as to pass through the laminated substrates 1, 2, 3. The connection hole 24 is a blind via-hole for electrically connecting the land 12 of the inner substrate 1 with a land of the upper outer substrate 2. The connection hole 25 is a through-hole for electrically connecting the land 12 of the inner substrate 1 with lands of the upper and lower outer substrates 2, 3. The connection hole 25 as a through-hole is preferably formed by a drill or a punch.

After the formation of the connection holes 21, 22, 23, 24, 25, the resultant preliminary multilayer printed circuit board is subjected to plating treatment, such as electroless plating and electrolytic plating, so that the outer surfaces of the upper and lower outer substrates 2, 3 and the inner surfaces of the connection holes 21, 22, 23, 24, 25 are plated to form a plating layer 27 adhering thereto, as shown in Fig. 6. As a result of the formation of the plating layer 27, the lands of the hybrid modules 14, 15 are electrically connected with lands of the outer substrates 2, 3, and the connection holes 24, 25 become a blind via-hole and a through-hole, respectively. Therefore, as a result of the formation of the plating layer 27, the hybrid modules 14, 15 are electrically connected with the outer substrates 2, 3, so that while being buried in the laminated substrates, the hybrid modules 14, 15 can function as an electronic component or an electronic circuit including electronic components electrically connected in a network fashion.

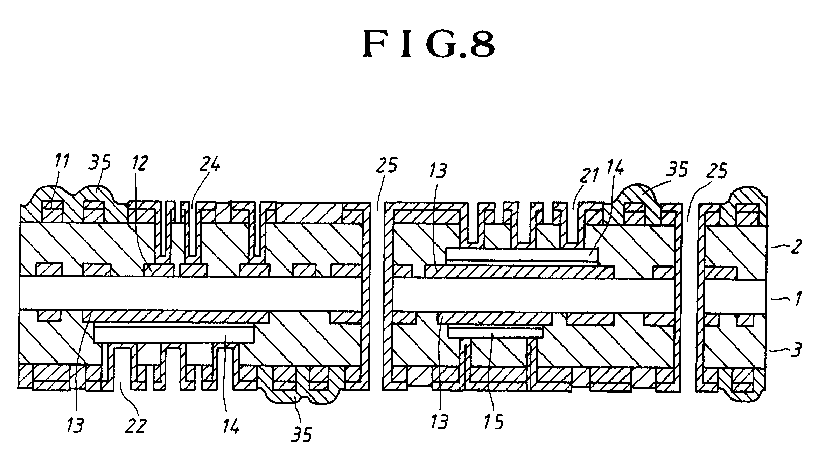

Subsequently, the copper foils 2b, 3b of the outer substrates 2, 3 and the plating layer 27 formed on the copper foils 2b, 3b are subjected to a treatment comprising application of a photosensitive resin, light exposure and etching for pattern formation to form a circuit 29 and lands on the outer substrates 2, 3. In Fig. 7, numeral 30 designates a land for electrically connecting the inner substrate 1 and the outer substrates 2, 3. A land 31 is one for electrically connecting the hybrid modules 14, 15 with the outer substrates 2, 3. After the formation of the circuit 29 and the lands 30, 31, a solder resist 35 is applied to the outer surfaces of the outer substrate 2, 3 to thereby obtain a multilayer printed circuit board as shown in Fig. 8.

As apparent from the foregoing, in this Example, the hybrid modules 14, 15 are sandwiched between the inner substrate 1 and the outer substrates 2, 3 and are electrically connected with the inner substrate 1 and the outer substrates, so that a structure results such that desired electronic components or a desired electronic circuit including electronic components is buried in the laminated substrate board. Due to this burial of electronic components in addition to the mounting of electronic components on the outer surfaces of a multilayer printed circuit board, the packaging density of electronic components can be remarkably increased in the multilayer printed circuit board of the present invention. Further, since the electric connection of the hybrid modules 14, 15 to the outer substrates 2, 3 can be performed concurrently with the formation of circuits and lands on the outer substrates 2, 3, operations for connection, such as wire bonding, become unnecessary and the electric connection can be performed at high efficiency with high precision. Still further, since the hybrid modules 14, 15 buried in the multilayer printed circuit board are connected via the plating layer 27 to lands of the outer substrates 2, 3, heat conduction is effectively performed to ensure excellent heat radiation efficiency and hence operations not adversely affected by temperatures. Still further, since the hybrid modules 14, 15 are individually sandwiched between the copper foils of the inner substrate 1 and those of the outer substrates 2, 3, electromagnetic wave shield is ensured to thereby minimize noise.

The above Example should not be construed as limiting the scope of the present invention, and various modifications can be made. For example, the multilayer printed circuit board of the present invention may be comprised of two printed circuit substrates or of four or more printed circuit substrates. The electric connection of the hybrid modules to the outer substrates may be performed through connection holes filled with a conductor paste. Also, the hybrid modules are not limited to a module comprising a ceramic substrate and, disposed thereon, electronic components. Further, an electronic component, such as a semiconductor chip, per se may be die-bonded as a hybrid module to the inner substrate.

As described above, in the present invention, a hybrid module having electronic component or electronic circuit functions is buried in the printed circuit board and desirable electric connection is performed therefor, so that the packaging density of electronic components can be increased. Further, since the electric connection of the hybrid module to the printed circuit substrate can be performed concurrently with the manufacturing of the multilayer printed circuit board, the electric connection can be effectively made with high precision.

## Claims

1. A multilayer printed circuit board comprising an inner printed circuit substrate having a hybrid module with electronic component functions die-bonded thereto and at least one outer printed circuit substrate laminated to said inner printed circuit substrate so that said hybrid module is sandwiched between said inner printed circuit substrate and said outer printed circuit substrate.

2. The multilayer printed circuit board according to claim 1, wherein said hybrid module is a module comprising a ceramic substrate and, disposed thereon so as to form a network, at least one member selected from the group consisting of a resistor, a capacitor and a semiconductor chip.

3. A method for manufacturing a multilayer printed circuit board, comprising the steps of:
(1) die-bonding a hybrid module with electronic component functions to an inner substrate having a circuit formed thereon,
(2) laminating at least one outer substrate to said inner substrate so that said hybrid module is sandwiched between said outer substrate and said inner substrate,
(3) forming connection holes in said outer substrate at least at a portion corresponding to a land of said hybrid module, and
(4) electrically connecting said hybrid module with said outer substrate through said connection hole formed at the portion corresponding to the land of the hybrid module.
